Europäisches Patentamt

European Patent Office

Office européen des brevets

(19)

(11) EP 1 391 972 A1

(12) EUROPEAN PATENT APPLICATION

(43) Date of publication:
25.02.2004 Bulletin 2004/09

(51) Int Cl.$^7$: H01S 5/10

(21) Application number: 03013829.1

(22) Date of filing: 18.06.2003

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 21.08.2002 US 227000

(71) Applicant: Agilent Technologies Inc
Palo Alto, CA 94306-2024 (US)

(72) Inventors:
• Tan, Michael R.
Menlo Park, CA 94025 (US)
• Lin, Chao-Kun
Fremont, CA 94955 (US)
• Corzine, Scott
Sunnyvale, CA 94087 (US)

(74) Representative: Liesegang, Eva et al
Forrester & Boehmert,
Pettenkoferstrasse 20-22
80336 München (DE)

(54) **Laser utilizing a microdisk resonator**

(57) A light source[50, 90] that includes first and second waveguides[21, 22] and a passive resonator[30] for coupling light between the waveguides. The waveguides include a gain region[23] for amplifying light of a desired wavelength, a transparent region[25], and an absorption region[27]. The passive resonator couples light of the desired wavelength between the first and second transparent regions of the first and second waveguides and has a resonance at that wavelength.

The resonator[30] is preferably a microdisk resonator. The index of refraction of the microdisk resonator can be altered to select the desired wavelength. A second microdisk resonator[101] having a different radius may be incorporated to increase the tuning range of the light source. The resonator is preferably constructed over the waveguides with an air gap[132] between the resonator and the substrate[20] in which the waveguides are constructed.

FIGURE 2

**Description**

**Field of the Invention**

The present invention relates to lasers, and more particularly, to lasers that utilize microdisk resonators.

**Background of the Invention**

Communication systems based on modulated light sources are well known to the art. In high-speed communication systems, the light source is typically a laser. Data is sent down a fiber by modulating the light from the laser. To increase the capacity of a fiber, wavelength-division-multiplexing is employed. In such systems, a number of separate communication channels are sent on a single fiber, each channel being sent on a light signal that differs slightly in wavelength from those of the other channels. There is a practical maximum number of channels that can be sent in this manner that is imposed by the optical amplifiers that are used as repeaters along the fiber and the spread in wavelength of the light generated by the lasers.

Hence, lasers having decreased line width would be particularly useful in increasing the capacity of an optical fiber communication path. The spread in wavelength of the output of a modulated laser is determined by the line width of the laser and the "chirp" introduced by modulating the laser. Increasing the cavity length is known to decrease the line width and chirp. However, large cavity length lasers are difficult to construct at a cost consistent with communication applications.

It has been suggested that the effective cavity length can be increased by including a high-Q resonator in the optical cavity (Liu, *et al.*, **IEEE Photonics Technology Letters, 14,** pp.600-602, May 2002)). However, the authors of this reference do not provide a design in which the output wavelength can be adequately tuned over the desired range of wavelengths and fabricated without the use of sub-micron lithographic techniques.

Broadly, it is the object of the present invention to provide an improved passive microdisk-based laser.

This and other objects of the present invention will become apparent to those skilled in the art from the following detailed description of the invention and the accompanying drawings.

**Summary of the Invention**

The present invention is a light source that includes first and second waveguides and a resonator for coupling light between the waveguides. In one embodiment, the first waveguide has a first gain region for amplifying light of a desired wavelength, a first transparent region, and a first absorption region. The first transparent region is non-absorbent for light of the desired wavelength, and the first absorption region absorbs light of that wavelength. The second waveguide has a second transparent region, and a second absorption region. The second transparent region is non-absorbent for light of the desired wavelength, and the second absorption region absorbs light of that wavelength. The passive resonator couples light of the desired wavelength between the first and second transparent regions of the first and second waveguides and has a resonance at that wavelength. The resonator is preferably a first microdisk resonator having a first radius. The index of refraction of the microdisk resonator can be altered to select the desired wavelength. Embodiments that include a second microdisk resonator having a second radius different from the first radius can provide an increased tuning range. The first gain region includes a quantum well layer having a first bandgap and the first transparent region includes a portion of that quantum well layer having a second bandgap, the second bandgap being different from the first bandgap. The resonator may include a quantum well layer having a third bandgap that is also different from the first bandgap. The absorption region may be the same as the first gain region, only unpumped so that it provides absorption rather than gain. The resonator is preferably constructed over the first and second waveguides with an air gap between the resonator and the substrate in which the waveguides are constructed. Embodiments in which the resonator is constructed in the same substrate as the waveguides may also be constructed.

The light source is preferably fabricated by depositing a lower cladding layer, an active layer that includes a quantum well layer having a predetermined bandgap, and a portion of a top cladding layer on a substrate. The quantum well layer is divided into first and second regions, the quantum well layer having a first bandgap in the first region and a second bandgap different from the first bandgap in a second region. The portion of the top cladding layer, the quantum well layer, and a portion of the lower cladding layer are then etched to form first and second waveguides, the first waveguide is located in both the first and second regions. The etched waveguides are then buried creating a buried heterostructure waveguide. The buried waveguides eliminate waveguide scattering losses and allow for the planarization of the structure for subsequent microdisk formation. After the waveguides are buried, the remainder of the top cladding layer is then deposited and the resonator is fabricated over the first and second waveguides, the resonator being connected to the first and second waveguides by the top cladding layer. The first and second bandgaps can be provided during the deposition of the quantum well layer through the use of selective-area growth techniques. In other embodiments, the second bandgap can be created by altering the first bandgap in the second region after the quantum well layer has been deposited through the use of impurity-induced or vacancy-induced disordering techniques. The resonator is preferably fabricated by depositing a patterned sacrificial layer on the top cladding layer, the sacrificial layer including holes in which the top cladding layer is exposed over the first and second waveguides. The layers that make up the resonator are then deposited and etched to form the resonator structure. Finally, the sacrificial layer is etched to provide a gap under the first resonator layer.

**Brief Description of the Drawings**

Figure 1 is a top view of a laser 10.

Figures 2 and 3 illustrate one embodiment of a microdisk resonator laser according to the present invention.

Figure 4 is a top view of a laser 100 according to the present invention that utilizes a second microdisk resonator to provide increased tuning.

Figures 5- 22 illustrate the fabrication of a microdisk resonator laser 100 at various stages in the fabrication process.

**Detailed Description of the Invention**

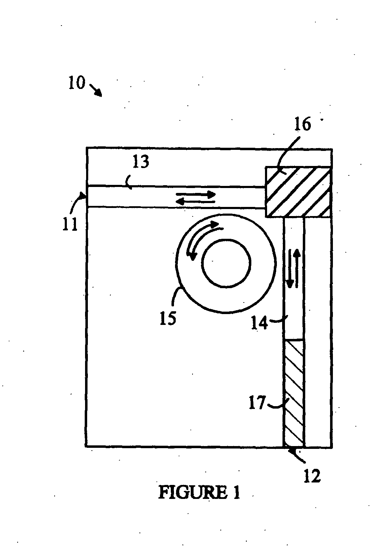

The manner in which the present invention provides its advantages can be more easily understood with reference to Figure 1, which is a top view of a laser 10 as suggested by Liu, et al. Laser 10 has a cavity that consists of waveguides 13 and 14 and microdisk resonator 15. The ends of the linear waveguides shown at 11 and 12 are cleaved to form mirrors. Light can be removed through either or both of the cleaved ends. Waveguide 14 includes a gain region 17 that amplifies the light traveling in the waveguide.

Microdisk resonator 15 couples that portion of the light amplified by the gain region that has a wavelength equal to one of its resonant wavelengths between waveguides 13 and 14. The resonant wavelengths of the disk resonator are given by

$$\lambda_0 = \frac{2\pi d n_e}{m} \tag{1}$$

where $n_e$ is the effective index of the mode in the ring resonator, d is it's diameter, and m is an integer value. Light that is not coupled between the waveguides is absorbed in an absorption region 16.

In the design shown in Figure 1, the microdisk resonator is in the same plane as the laser, and hence, must be fabricated from the same layers as the laser. This causes two problems. First, the gap separation between the edge of microdisk resonator 15 and each of the waveguides must be very small and tightly controlled. This spacing determines the fraction of the light travelling in the waveguides that is coupled to and from the microdisk resonator. Hence, the microdisk resonator and waveguides must be within a fraction of a wavelength of one another, i.e., less than 1 $\mu$m apart. To provide such accuracy, high-resolution lithography must be utilized which increases the cost of the device.

Second, the device must be tuned by altering the effective index of refraction of the microdisk resonator. To obtain a significant change in index of refraction effects such as the electro-optic effect, Franz-Keldysh effect, quantum confined stark effect, or carrier induced effects such as plasma and band-filling effects must be utilized. To utilize these effects, microdisk resonator 15 may include a bulk or quantum well region similar to that used in the gain region; however, the microdisk resonator quantum well material must have a composition that does not result in absorption of the light traveling in the microdisk resonator. Hence, the quantum well layer in the microdisk resonator which provides the tunable index of refraction must be different from that used in gain region 17. Providing a quantum well layer that is different in the two regions poses significant fabrication processes that substantially increase the cost of the device. It should also be noted that not all material systems used in semiconductor lasers are amenable to varying the composition of the quantum well layer at different locations on the chip.

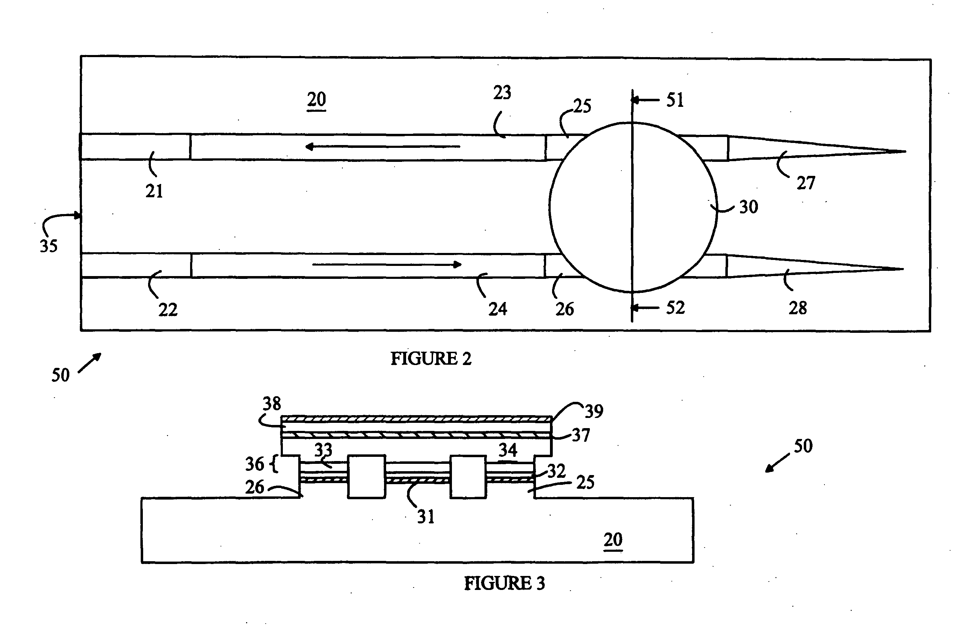

Refer now to Figures 2 and 3, which illustrate one embodiment of a microdisk resonator laser according to the present invention. Figure 2 is a top view of a laser 50 according to the present invention, and Figure 3 is an enlarged cross-sectional view of laser 50 through line 51-52 shown in Figure 2. Laser 50 is constructed on a substrate 20 by depositing the conventional layers of material including an n-contact layer in contact with the substrate and an n-cladding layer that defines the lower bound of the laser cavity. To simplify the drawings, these layers have been omitted.

An active layer 31, p-cladding layer 32 and p-contact layer 33 are deposited over the n-cladding layer. These layers are then etched to form two waveguides 21 and 22. The waveguides include active regions 23 and 24 that are defined by electrodes that are in contact with the p-contact layer. The faces of the waveguides are cleaved along edge 35 to form mirror surfaces that provide the ends of the laser cavity.

A microdisk resonator 30 is constructed over the transparent portions of the waveguides shown at 25 and 26. The transparent portions preferably absorb less than 10 percent of the light passing therethrough. Microdisk resonator 30 couples light at the resonance frequencies of the microdisk resonator between the two waveguides. Any light that is not coupled is radiated from the tapered portion of the waveguides shown at 27 and 28. Similarly, light that is not coupled may be absorbed in regions of the waveguide that are not pumped.

The manner in which microdisk resonator 30 is constructed will be discussed in more detail below. For the purposes of the present discussion, microdisk resonator 30 will be assumed to have a tunable index of refraction that is controlled by applying a potential across an index adjusting layer 37 and to have a Q greater than 10. Accordingly, the portion 38 of microdisk resonator 30 above the index adjusting layer 37 is preferably an n-contact material so that the microdisk resonator forms a p-i-n structure. The potential is applied between an electrode layer 39 and p-contact layer 33 of the laser section, which has been extended by the fabrication process such that layer 34 is an extension of the p-contact layer.

As noted above, the coupling of the microdisk resonator to the waveguides depends on the distance from the waveguide to the microdisk resonator. In the design shown in Figures 2 and 3, the coupling is adjusted by setting the distance from the top of cladding layer 32 to the bottom edge of microdisk resonator 30 as shown at 36 in Figure 3. This distance is determined by the thickness of the various layers that are deposited during the fabrication of the microdisk resonator. Since this thickness may be precisely controlled without the use of lithography, the present invention allows for a more predictable value of the coupling coefficient and also avoids the costly lithography discussed above.

In addition, the index-adjusting layer 37 is deposited separately from the active layer of the laser. Hence, the composition of this layer is not constrained by the composition of the quantum well layer in the laser.

It should be noted that the range of tuning that can be provided by adjusting the index of refraction of a single microdisk resonator is very limited. For example, the index of refraction can be varied by up to 0.002 by using free carrier injection techniques as taught in K. Djordjev, *et al.*, "High-Q Vertically Coupled InP Microdisk Resonators", **IEEE PHOTONICS TECHNOLOGY LETTERS,** Vol 14, No 3, pp.331-333, March 2002. However, the range can be increased substantially by including a second disk having a different radius.

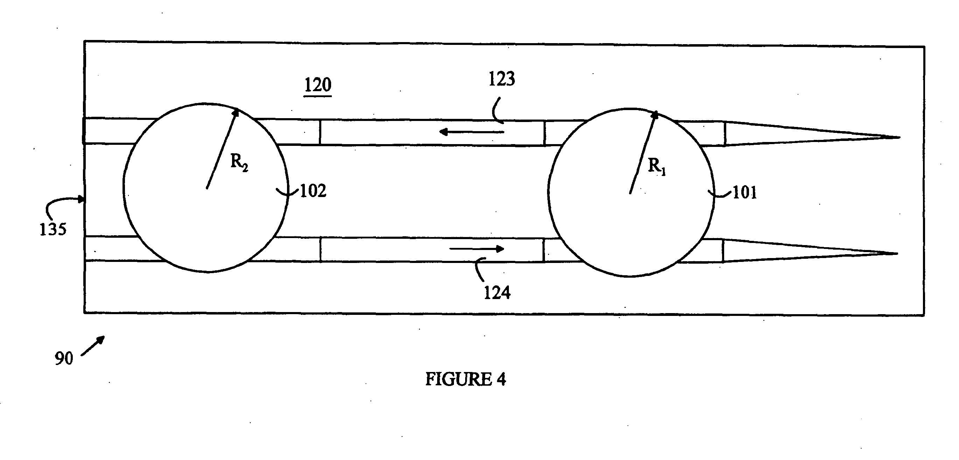

Refer now to Figure 4, which is a top view of a laser 90 according to the present invention that utilizes two microdisk resonators to provide increased tuning. Laser 90 includes two waveguides having gain regions 123 and 124 constructed on a substrate 120 in a manner analogous to that described above. The waveguides are cleaved on edge 135 to form the mirrors for the laser cavities. The laser utilizes two microdisk resonators shown at 101 and 102. Laser 90 outputs light of a wavelength that matches a resonance of each of the microdisk resonators. If the diameters of the microdisk resonators are different, the wavelengths that correspond to resonances of both microdisk resonators will correspond to different values of m in Eq. (1). Hence, these wavelengths will be separated by more than the separation introduced by differences in the indices of refraction. Accordingly, small changes in the index of refraction of one or both of the microdisk resonators are magnified via the Vernier effect as taught in U. S. Patent 4896325.

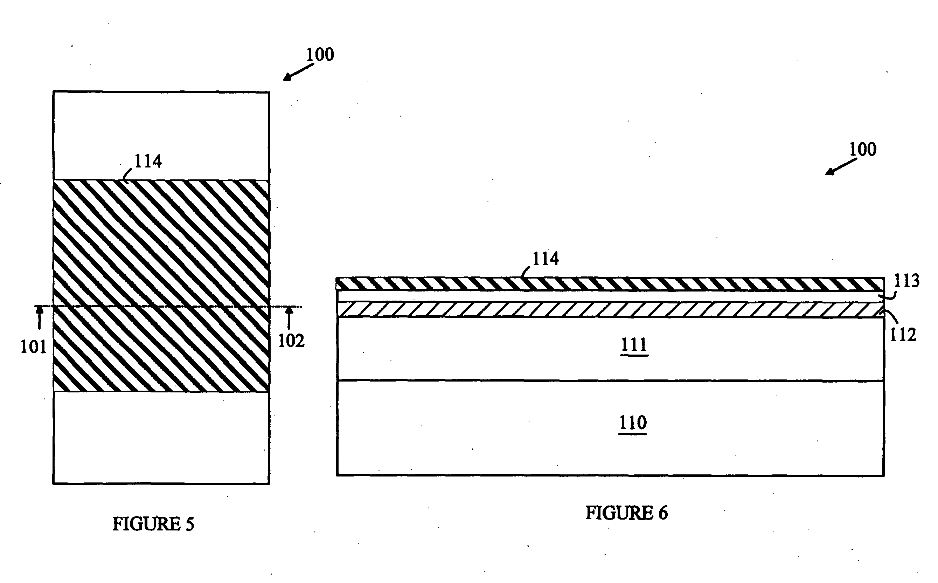

The preferred method for fabricating a passive microdisk resonator laser will now be discussed with reference to Figures 5-22, which illustrate the fabrication of a microdisk resonator laser 100 at various stages in the fabrication process. The odd numbered figures are top views of laser 100 at various stages in the fabrication processes, and the even numbered figures are enlarged cross-sectional views of laser 100 through line 101-102 at the corresponding points in the fabrication process. Refer now to Figures 5 and 6, which are top and cross-sectional views, respectively, of laser 100 after part of the layers used to construct the gain region have been deposited. Figure 6 is a cross-sectional view through line 101-102 shown in Figure 5. The various layers are constructed on a substrate 110. To simplify the drawings, the conventional n-contact layer is included in the substrate 110. An n-InP cladding layer 111, an active layer 112, and a p-InP upper cladding layer 113 are deposited on the substrate in the conventional manner. The cladding layer 113 is preferably undoped or lightly doped, as the p-InP dopants in the subsequent layers tend to diffuse, and hence, will provide doping to this layer without substantially contaminating the layers under layer 113.

A $SiO_2$ film 114 is sputtered on cladding layer 113 in the coupling region that will underlie the microdisk resonator. The quantum well layer(s) in the active region under film 114 are then disordered to render the active layer in this region transparent to light of the wavelength generated in the gain region. The disordering can be accomplished by high temperature annealing utilizing impurity-induced disordering or vacancy-induced disordering. Since these techniques are known to the art, they will not be discussed in detail here. It is sufficient to note that the disordering alters the bandgaps in the quantum well layers. If the quantum well layers were left intact and have the same composition as those in the gain region, the portion of the waveguide that couples the microdisk resonator to the gain region would absorb the light generated in the gain region. Other methods of rendering the quantum well layers transparent to the desired wavelength will be discussed below.

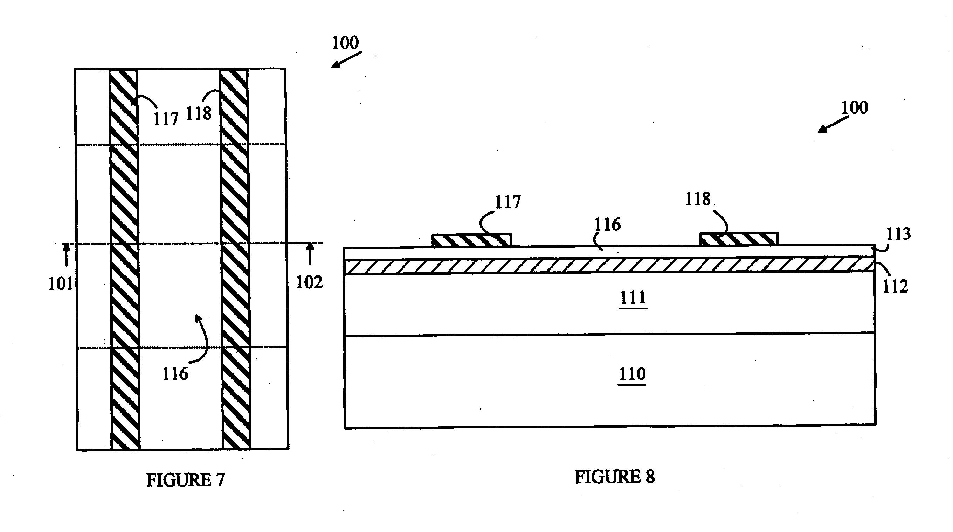

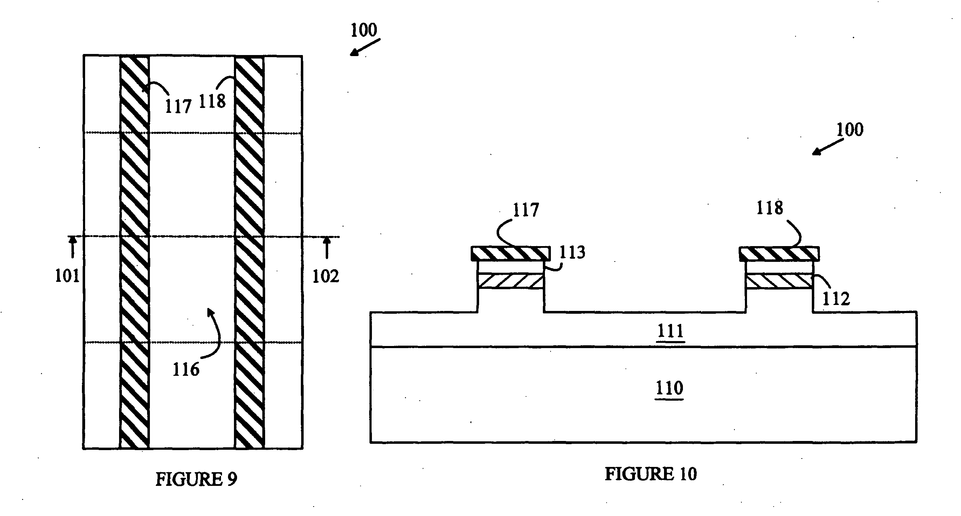

The dielectric mask used to disorder this region is then removed, leaving the disordered region 116 as shown in Figures 7 and 8. The waveguides are defined by two dielectric masks shown at 117 and 118. After the deposition of masks 117 and 118, the layers are etched as shown in Figures 9 and 10 to define the waveguides both in the gain section and under the coupling region under the microdisk resonator. In general, the etching operation will undercut the masks.

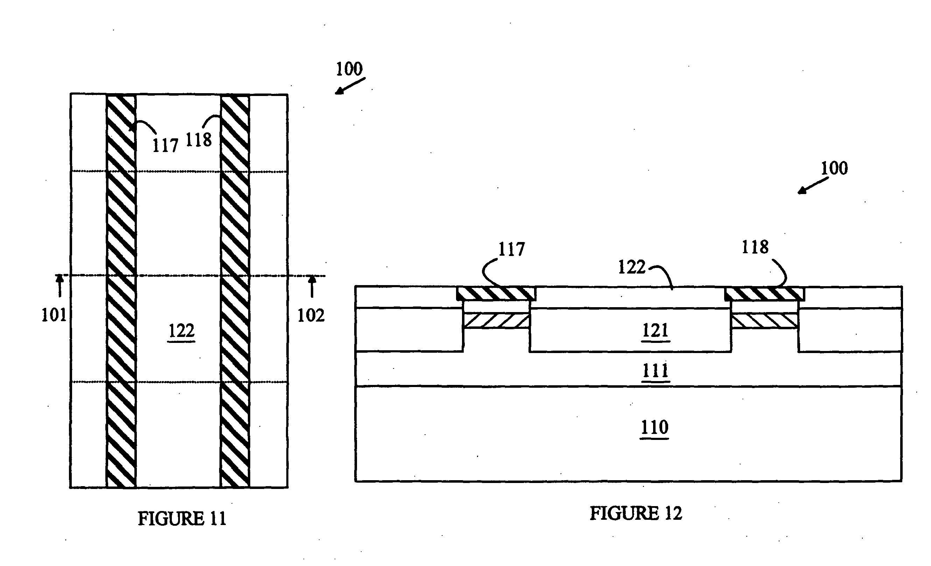

Refer now to Figures 11 and 12. The area between the waveguides is then filled with a material with a dielectric constant different from that of the waveguides and which provides electrical insulation. In the preferred embodiment of the present invention, this function is provided by two layers. The first layer consists of an InP:Fe layer 121 that provides a high resistance to the flow of electrons. The second layer is an n-InP:Si layer 122 that will prevent inter-diffusion between Fe and Zn during the overgrowth of the p-InP:Zn top cladding layer.

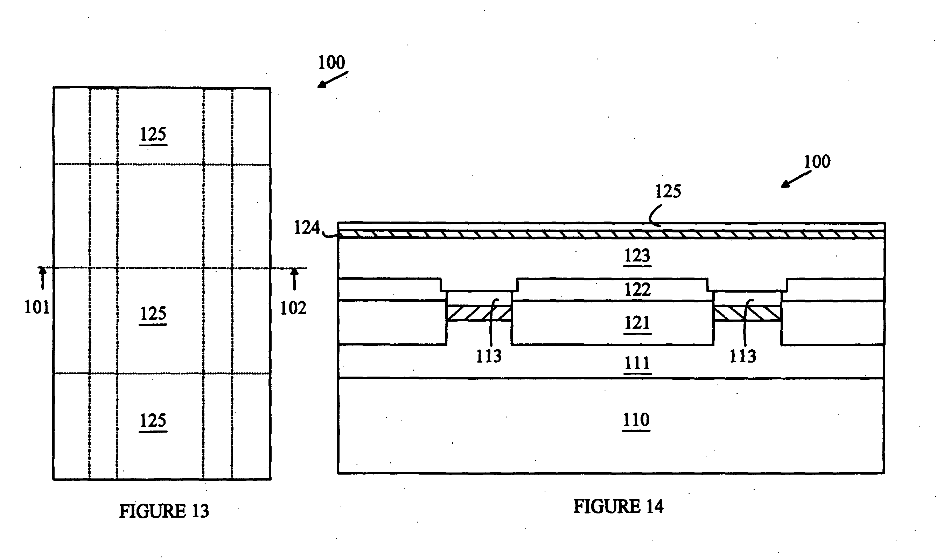

Now refer to Figures 13 and 14. The waveguide masks 117 and 118 are then removed, and a p-InP layer 123 is grown on layers 122 and the remainder of layer 113 as shown in Figures 13 and 14. Layer 123 effectively extends the p-cladding layer above the waveguides. An etch stop layer of InGaAs 124 is then deposited over layer 123, and a layer 125 of InP is grown in the etch stop layer to provide a seed layer for further deposition of InP. It should be noted that the InGaAs layer 124 can provide the conventional p-contact function in the gain region.

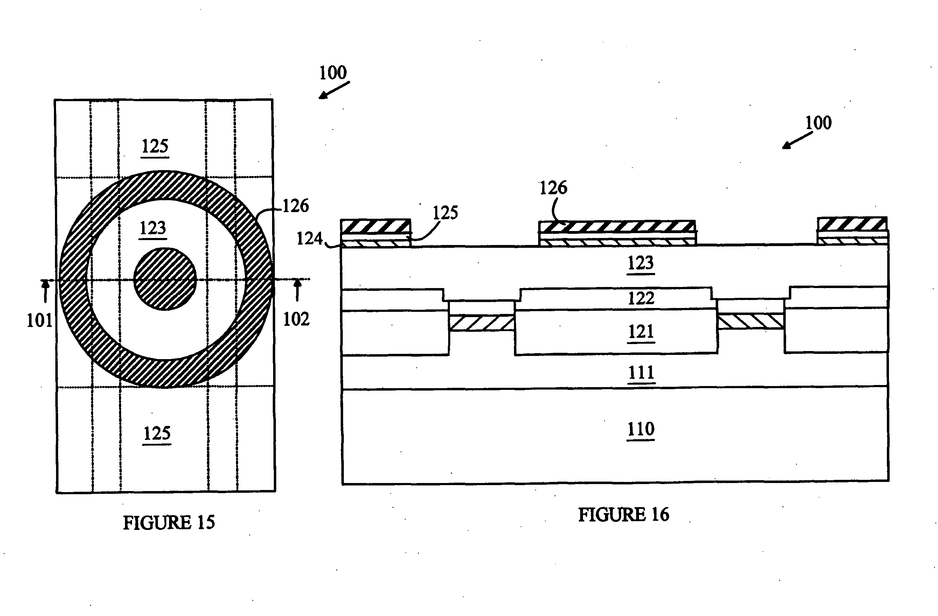

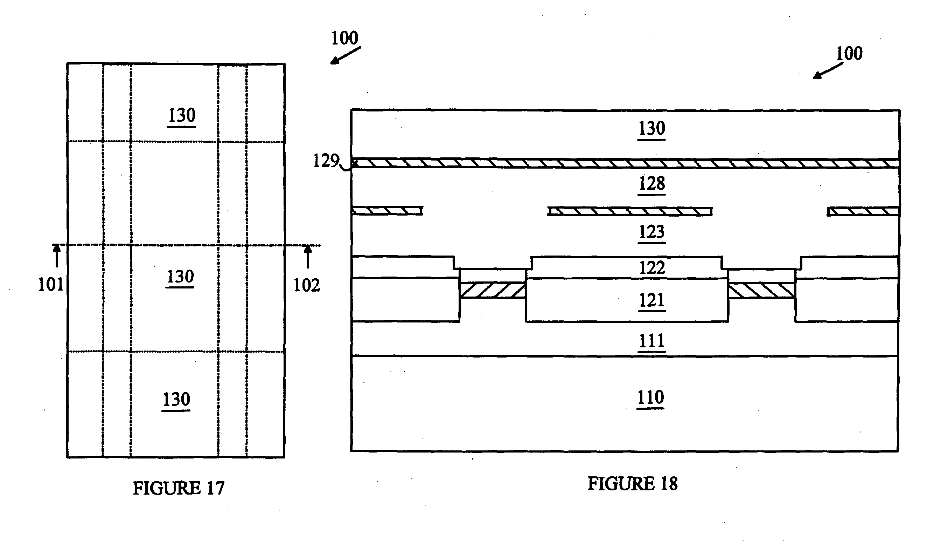

Next, a mask 126 that defines the lower boundary of the microdisk resonator is deposited and layers 124 and 125 are etched back to layer 123 in the region that is to receive the microdisk resonator as shown in Figures 15 and 16. Mask 126 is then removed and the layers that makeup the microdisk resonator are grown as shown in Figures 17 and 18. The microdisk resonator layers include a p-InP layer 128, which is grown from the seed layer over the InGaAs layer 124 and the exposed regions of layer 123. An active layer 129 whose index of refraction changes with the electric field applied across layer 129 is then deposited followed by an n-InP layer 130.

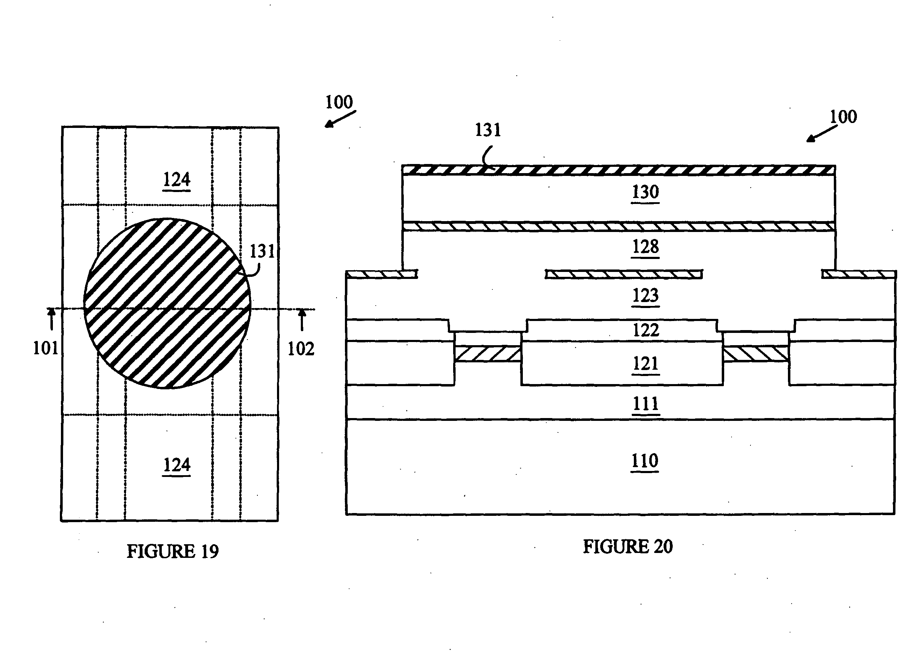

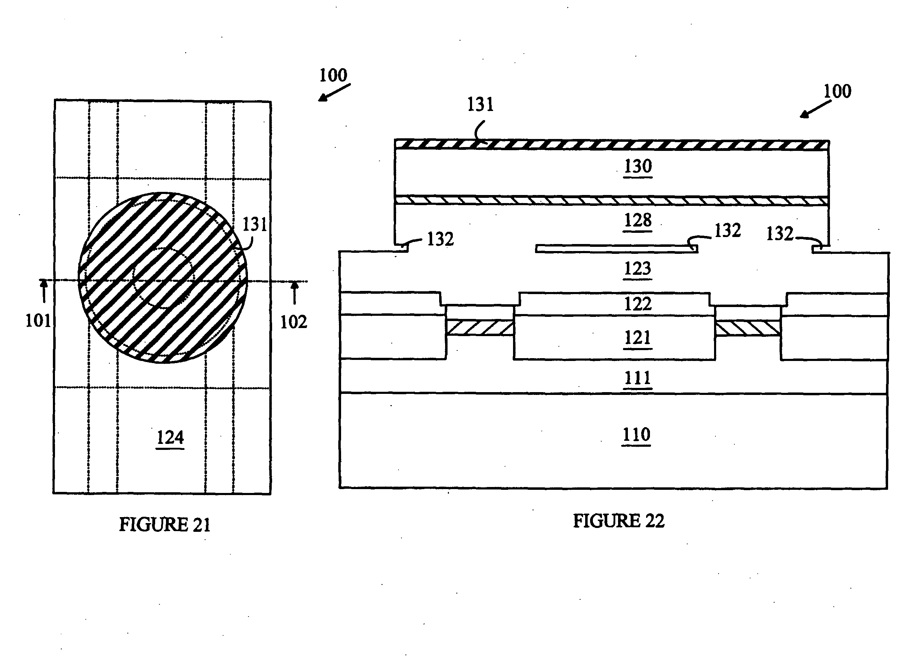

An etch mask 131 is then deposited over layer 130 to define the microdisk resonator, and the microdisk resonator layers are etched back to the InGaAs layer 124 as shown in Figures 19 and 20. Finally, the InGaAs layer is etched in the region that includes the resonator leaving an air gap 132 under the microdisk resonator between the microdisk resonator and layer 123 as shown in Figures 21 and 22. The air gap substantially increases the Q of the microdisk resonator. Without the air gap, energy in the microdisk can be lost vertically into the substrate if the effective index of the disk waveguide is below the bulk index of the substrate. In the absence of the air gap, the amount of energy loss into the substrate depends on the thickness of the material between the microdisk and the waveguides. In principle, a thick buffer layer may be used to reduce this loss, however, a trade-off must be made between the thickness of the buffer layer and the coupling factor between the top of the waveguide and the resonator. Accordingly, an air gap is preferred. As noted above, the InGaAs layer 124 may be left over the gain regions to provide a p-contact layer.

The above-described embodiments of the present invention utilized disordering to alter the absorption of the active region in the portion of the waveguide that connects the gain region to the microdisk resonator. However, other methods for reducing the absorption of the active region in this part of the waveguide may also be utilized. In indium phosphide lasers, the quantum wells are typically constructed from $In_xGa_{1-x}As_yP_{1-y}$. The relative amount of In and Ga determine the bandgaps of the quantum wells, and hence, the wavelength at which the quantum well layer will absorb light. By adjusting the In concentration in the passive waveguide region, the absorption wavelength can be shifted such that the active layer does not absorb light in this region.

A technique known as "selective-area growth" can be used to shift the bandgap of InGaAsP layers across the device. This technique is based on the observation that indium does not deposit on $SiO_2$. Hence, if the area that is to have an increased In concentration is bounded by $SiO_2$ masks, some of the indium that would have been deposited on the mask area moves into the area between the mask and increases the concentration of indium in that region.

The index of refraction of the microdisk may be altered by altering the electric field across microdisk, the carrier density in the microdisk and/or the temperature of the microdisk. The modulation of the electric field can alter the refractive index either by the linear electrooptic effect or electrorefractive effects such as Franz-Keldysh effect and the quantum confined stark effect. Modulation of the carrier density in the microdisk can utilize either the Plasma effect or the band-filling effect. Typical index changes achievable in the InGaAsP material system at 1.55μm are tabulated in Table 1.

TABLE 1

| Electric Field @ 65kV/cm | Linear electrooptic effect | $\Delta n \sim 5 \times 10^{-8}$ |
|---|---|---|
| | Electro-refractive effect | Franz-Keldysh: $\Delta n \sim 3. \times 10^{-6}$ QCSE: $\Delta n \sim 0.00056$ |
| Carrier effect @ $N = 5 \times 10^{17}$ cm$^{-3}$ | Plasma effect | $\Delta n \sim -0.002$ |
| | Band filling effect | $\Delta n \sim -0.001$ |

Comparable changes in the index of refraction are obtained for the GaAs/AlGaAs material system. The signs of the refractive index changes depend on the operating wavelength. The refractive index increases with temperature at a rate of dn/dT $\sim 10^{-4}$/K.

The above-described embodiments of the present invention include an absorption section that absorbs the light from each waveguide that is not coupled to the other waveguide by the microdisk resonator. The absorption section may include the same quantum well layer as the gain region. In this case, the absorption of the quantum well layer improves the overall absorption of this section of the waveguide.

The above-described embodiments of the present invention include a gain section in each of the waveguides. However, embodiments in which the gain section is omitted from one of the waveguides may also be practiced. In this case, the quantum well layer in that section must be altered to assure that the waveguide is transparent to light of the desired wavelength. This can be accomplished by altering the bandgap of the quantum well layer in this region using the techniques described above with respect to the fabrication of the transparent regions of the waveguide over which the microdisk resonator is fabricated.

While the preferred embodiment of the present invention utilizes a resonator that is constructed over the substrate containing the waveguides, embodiments in which the resonator is constructed in the same substrate can also be practiced. In this case, the quantum well layer utilized in the active region will also be present in the resonator. Accordingly, the bandgap of that layer must be altered to render the layer transparent to the desired wavelength in the region in which the resonator is fabricated. This can be accomplished by altering the bandgap of the quantum well layer in this region using the techniques described above with respect to the fabrication of the transparent regions of the waveguide over which the microdisk resonator is fabricated.

The above-described embodiments of the present invention have utilized quantum well layers for the various gain layers. However, other forms of gain layers including bulk layers may be utilized.

Various modifications to the present invention will become apparent to those skilled in the art from the foregoing description and accompanying drawings. Accordingly, the present invention is to be limited solely by the scope of the following claims.

**Claims**

1. A light source comprising:

    a first waveguide (12) including a first gain region (23) for amplifying light of a desired wavelength and a first absorption region (27), said first absorption region absorbing light of said wavelength;

    a second waveguide (22) including a second absorption region (28), said second absorption region absorbing light of said wavelength;

    a passive resonator (30) for coupling light of said wavelength between said first and second waveguides (12,22), said resonator having a resonance at said wavelength.

2. The light source of claim 1 wherein said first waveguide (12) comprises a first transparent region (25), wherein said second waveguide (22) comprises a second transparent region (26), and wherein said passive resonator (30) couples light between said first and second transparent regions (25,26), said first and second transparent regions being non-absorbent for light of said wavelength.

3. The light source of claim 1 or 2, wherein said second waveguide (22) comprises a second gain region for amplifying the light at the desired wavelength.

4. The light source of one of the preceding claims wherein said first absorption region (27) comprises a tapered section of said first waveguide.

5. The light source of one of the preceding claims wherein said resonator comprises a first microdisk resonator (101) having a first radius.

6. The light source of claim 5 wherein said resonator further comprises a second microdisk resonator (102) having a second radius, said second radius being different from said first radius.

7. The light source of one of the preceding claims wherein said resonator comprises an active layer (129) having an index of refraction responsive to a control signal.

8. The light source of claim 2 and one of the preceding claims wherein said first transparent region (25) absorbs less than 10 percent of said light passing therethrough.

9. The light source of claim 2 and one of the preceding claims wherein said first gain region (23) comprises a layer having a first bandgap and said first transparent region (25) comprises a layer having a second bandgap, said second bandgap being different from said first bandgap.

10. The light source of claim 9 wherein said resonator comprises a layer (129) having a third bandgap, said third bandgap being different from said first bandgap.

11. The light source of one of the preceding claims wherein said resonator (30) has a Q greater than 10.

12. The light source of claim 2 and one of the preceding claims wherein said first and second waveguides comprise regions of a substrate (20) and wherein said resonator (30) comprises a structure separate from said substrate, said resonator being connected to said substrate in regions (36) proximate to said first and second transparent regions and separated from said substrate in other regions of said substrate.

13. The light source of claim 12 wherein said resonator overlies said waveguides.

14. The light source of claim 13 wherein said waveguide comprises a cladding layer and where said light source further comprising a gap (132) between said substrate and said resonator, said gap having an index of refraction less than that of said cladding layer of said waveguide.

15. The light source of claim 14 wherein said gap (132) is filled with a gas.

FIGURE 1

FIGURE 2

FIGURE 3

EP 1 391 972 A1

FIGURE 4

100

114

101 102

FIGURE 5

EP 1 391 972 A1

100

114

113

112

111

110

FIGURE 6

**FIGURE 7**

**FIGURE 8**

EP 1 391 972 A1

**FIGURE 10**

100

118  112

117  113

111

110

**FIGURE 9**

100

102

117 118

116

101

FIGURE 12

FIGURE 11

14

EP 1 391 972 A1

100

125

125

125

125

101

102

**FIGURE 13**

100

125

124

123

122

121

111

110

113

113

**FIGURE 14**

EP 1 391 972 A1

100

125

126

123

101

102

125

**FIGURE 15**

100

126

125

124

123

122

121

111

110

**FIGURE 16**

FIGURE 17

FIGURE 18

EP 1 391 972 A1

100

124

131

101    102

124

**FIGURE 19**

131

100

130

128

123

122

121

111

110

**FIGURE 20**

EP 1 391 972 A1

**100**

**131**

**FIGURE 21**

124

101

102

131

**FIGURE 22**

**100**

131

130

128

132

132

132

123

122

121

111

110

19

**European Patent Office**

## EUROPEAN SEARCH REPORT

Application Number

EP 03 01 3829

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X,D | BIN LIU ET AL: "Wide tunable double ring resonator coupled lasers" IEEE PHOTONICS TECHNOLOGY LETTERS, MAY 2002, IEEE, USA, vol. 14, no. 5, pages 600-602, XP002257902 ISSN: 1041-1135 | 1,2,5-11 | H01S5/10 |
| Y | * page 600 - page 601; figure 1 * | 4,12-15 | |
| X | LIU B ET AL: "PASSIVE MICRORING-RESONATOR-COUPLED LASERS" APPLIED PHYSICS LETTERS, AMERICAN INSTITUTE OF PHYSICS. NEW YORK, US, vol. 79, no. 22, 26 November 2001 (2001-11-26), pages 3561-3563, XP001091714 ISSN: 0003-6951 | 1-3,5, 7-11 | |
| Y | * page 3561; figure 1 * | 4,12-15 | |
| Y,D | DJORDJEV K ET AL: "HIGH-Q VERTICALLY COUPLED INP MICRODISK RESONATORS" IEEE PHOTONICS TECHNOLOGY LETTERS, IEEE INC. NEW YORK, US, vol. 14, no. 3, March 2002 (2002-03), pages 331-333, XP001122920 ISSN: 1041-1135 * page 331; figures 1,2 * | 12-15 | |
| Y | US 4 372 641 A (JOHNSON LEO F ET AL) 8 February 1983 (1983-02-08) * abstract; figures 1,2 * * column 2, line 58-63 * | 4 | TECHNICAL FIELDS SEARCHED (Int.Cl.7) H01S G02B |
| Y | US 6 411 752 B1 (KOKUBUN YASUO ET AL) 25 June 2002 (2002-06-25) * abstract; figures 5A,5B * | 12-15 | |
| A | * column 9, line 55 - column 10, line 1 * | 7 | |

-/--

The present search report has been drawn up for all claims

| Place of search | Date of completion of the search | Examiner |
|---|---|---|
| MUNICH | 15 October 2003 | Marani, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

**European Patent Office**

**EUROPEAN SEARCH REPORT**

Application Number

EP 03 01 3829

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2002/037023 A1 (MARGALIT MOTI ET AL) 28 March 2002 (2002-03-28) * abstract; figure 7A * --- | 1-11 | |
| A | US 2002/094150 A1 (LEE KEVIN K ET AL) 18 July 2002 (2002-07-18) * abstract; figures 1A,3A,5 * --- | 1-11 | |
| A,D | US 4 896 325 A (COLDREN LARRY A) 23 January 1990 (1990-01-23) * abstract; figure 8 * ----- | 7 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 15 October 2003 | Marani, R |

EPO FORM 1503 03.82 (P04C01)

EP 1 391 972 A1

**ANNEX TO THE EUROPEAN SEARCH REPORT
ON EUROPEAN PATENT APPLICATION NO.**
EP 03 01 3829

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2003

| Patent document cited in search report | | Publication date | Patent family member(s) | | Publication date |
|---|---|---|---|---|---|
| US 4372641 | A | 08-02-1983 | NONE | | |
| US 6411752 | B1 | 25-06-2002 | WO | 0050938 A1 | 31-08-2000 |
| US 2002037023 | A1 | 28-03-2002 | AU | 8802601 A | 22-03-2002 |
| | | | CA | 2421657 A1 | 14-03-2002 |
| | | | EP | 1316129 A2 | 04-06-2003 |
| | | | WO | 0221650 A2 | 14-03-2002 |
| US 2002094150 | A1 | 18-07-2002 | AU | 1297502 A | 02-04-2002 |
| | | | CA | 2423008 A1 | 28-03-2002 |
| | | | WO | 0225338 A2 | 28-03-2002 |
| | | | US | 2002090160 A1 | 11-07-2002 |
| | | | US | 2002090163 A1 | 11-07-2002 |
| US 4896325 | A | 23-01-1990 | WO | 9002429 A1 | 08-03-1990 |

EPO FORM P0459

For more details about this annex : see Official Journal of the European Patent Office, No. 12/82

22